# EUROPEAN PATENT APPLICATION

(11) **EP 4 848 580 A1**
(43) Date of publication of application: **02.12.2026**
(21) Application number: 26152188.4
(22) Date of filing: 15.01.2026
(51) Int. Cl.: H03F 1/02, H03F 1/56, H03F 3/24

(54) **POWER AMPLIFIERS INCLUDING PHASE AND GROUP DELAY COMPENSATOR FOR PHASE AND GROUP DELAY BALANCES WITHIN FREQUENCY BAND**

(30) Priority: 30.05.2025 US 202563815427 P; 22.07.2025 US 202563848772 P; 26.11.2025 US 202519402748
(71) Applicant: TTM Technologies North America, LLC, St. Louis, MO 63141 (US)
(72) Inventor: Mei, Chong, Jamesville (US)
(74) Representative: Greaves Brewster LLP

(57) **Abstract**

A power amplifier system (400) includes a power splitter (402) having a first power output (403B) with a phase difference from a second power output (403D). The system includes a phase and group delay compensator (300) including two pairs of transmission lines with at least one of the two pairs of transmission lines being coupled. The system includes a first amplifier (404A) having a first output in a first path (410A) and a second amplifier (404B) having a second output in a second path (410B). The system also includes a power combiner (407) having a transmission line (406) coupled to the first output of the first amplifier (404A) and the second output of the second amplifier (404B). The transmission line (406) of the power combiner (407) is configured to compensate for the phase difference of the splitter (402) at a center frequency. The compensator (300) is configured to reduce phase differences and group delay differences between the first path (410A) and the second path (410B) within a frequency band.

## Description

### CROSS-REFERENCE TO RELATED PATENT APPLICATIONS

This patent application claims priority from U.S. Patent Application Serial No. 63/815,427 filed on May 30, 2025, from U.S. Patent Application Serial No. 63/848,772 filed on July 22, 2025, and from U.S. Patent Application Serial No. 19/402,748 filed on November 26, 2025.

### FIELD

The disclosure is directed to power amplifiers including phase and group delay compensator. In particular, the compensator is configured to compensate for phase and group delay balances within a frequency band.

### BACKGROUND

Doherty power amplifiers (PA) are widely used in wireless infrastructure to improve power-added efficiency (PAE) for communication applications. The Doherty power amplifiers enable radio frequency (RF) power amplifier designers to maximize efficiency, power, bandwidth, and yield without compromising linearizability. The Doherty power amplifiers can accommodate signals with high peak-to-average power ratios by using two amplifier circuits to accommodate different signal levels. The Doherty power amplifiers can achieve a high level of linearity while retaining good power efficiency.

### BRIEF SUMMARY

In one aspect, a phase and group delay compensator includes a first input port; a second input port; a first output port; a second output port; a first pair of transmission lines having a first path input at the first input port and a first path output at the first output port; and a second pair of transmission lines having a second path input at the second input port and a second path output at the second output port, wherein at least one of the first pair or the second pair of transmission lines is coupled, wherein the phase and group delay compensator is configured to reduce phase differences and group delay differences within a frequency band between the first path output and the second path output.

In some aspects, the phase and group delay compensator may be a standalone surface-mountable device.

In some aspects, the phase and group delay compensator may be part of an integrated circuit (IC).

In some aspects, a power amplifier system may include the phase and group delay compensator. The power amplifier system may further include a power splitter including a first port and a second port, wherein a first power output from the first port may have a phase difference from a second power output from the second port. The power amplifier system may further include a first amplifier having a first input and a first output in the first path. The power amplifier system may further include a second amplifier having a second input and a second output in the second path. The power amplifier system may further include a power combiner having a transmission line having a first end coupled to the first output of the first amplifier and a second end coupled to the second output of the second amplifier, wherein the transmission line of the power combiner may be configured to compensate for the phase difference of the power splitter at a center frequency.

In some aspects, the at least one of the first pair or the second pair of transmission lines may have a distance between the first pair or the second pair of transmission lines that is small enough to couple the first pair or the second pair of transmission lines.

In some aspects, the at least one of the first pair or second pair of transmission lines may have a distance between the first pair of transmission lines or the second pair of transmission lines that is large enough to uncouple the first pair of transmission lines or the second pair of transmission lines.

In some aspects, the first path output along the first path may combine with the second path output along the second path at the second end of the transmission line of the power combiner.

In some aspects, the power amplifier system may further include a matching component configured to match a resistance at the second end of the transmission line of the power combiner to a target resistance for RF output.

In some aspects, the first amplifier may include a main branch of a Doherty amplifier, and the second amplifier may include a peaking branch of the Doherty amplifier.

In some aspects, the power splitter may be a hybrid coupler.

In some aspects, the second port of the power splitter may be a DC port and may have a phase delay of 90° from the first output through the first port of the power splitter. The transmission line of the power combiner may be configured to shift phase by 90°.

In some aspects, the power splitter may include a first input port configured to input an RF (radio frequency) power and a second input port coupled to a resistor having a resistance of 50 ohms and being grounded.

In some aspects, a method is provided for designing the phase and group delay compensator. The method may include selecting a center frequency and a frequency bandwidth for the power amplifier system and performing simulations for the phase and group delay compensator based upon the center frequency, the frequency bandwidth, and a target group delay balance for the power amplifier system, wherein the phase and group delay compensator is configured to reduce phase differences and group delay differences within the frequency bandwidth and to meet the target group delay balance; and selecting a first degree of coupling between the first pair of transmission lines and a second degree of coupling between the second pair of transmission lines based upon results from the simulations.

In some aspects, a first distance between the first pair of transmission lines may be selected to be small enough to couple the first pair or the second pair of transmission lines, and a second distance between the first pair of transmission lines or the second pair of transmission lines may be selected to be large enough to uncouple the second pair of transmission lines.

In some aspects, the method may also include determining the first distance between the first pair 2; and determining a layout for the surface-mountable device based upon simulations, wherein the first degree of coupling or the second degree of coupling may increase reversely with a respective distance between a respective pair of transmission lines such that the first degree of coupling or the second degree of coupling becomes stronger when the respective distance between the respective pair of transmission lines becomes shorter. The method may also include determining a group delay balance and a phase difference of the phase and group delay compensator between the first path and the second path within the frequency bandwidth.

In another aspect, a power amplifier system may include a power splitter including a first output port and a second output port, wherein a first power output from the first output port has a phase difference from a second power output from the second output port. The power amplifier system also may include a phase and group delay compensator including a first pair of transmission lines and a second pair of transmission lines, wherein at least one of the first pair or the second pair of transmission lines is coupled. The power amplifier system may also include a first amplifier having a first input and a first output in a first path. The power amplifier system may also include a second amplifier having a second input and a second output in a second path. The power amplifier system may also include a power combiner having a transmission line having a first end coupled to the first output of the first amplifier and a second end coupled to the second output of the second amplifier. The transmission line of the power combiner is configured to compensate for the phase difference of the power splitter at a center frequency. The phase and group delay compensator is configured to reduce phase differences and group delay differences between the first path and the second path within a frequency band.

In another aspect, a method is provided for designing a phase and group delay compensator in a power amplifier system. The method may include selecting a center frequency and a frequency bandwidth for the power amplifier system. The power amplifier system may include a power splitter including a first output port and a second output port, wherein a first power output from the first output port has a phase difference from a second power output from the second output port. The power amplifier system may also include a phase and group delay compensator including a first pair of transmission lines and a second pair of transmission lines, wherein at least one of the first pair or the second pair of transmission lines is coupled. The power amplifier system may also include a first amplifier having a first input and a first output in a first path and a second amplifier having a second input and a second output in a second path. The power amplifier system may also include a power combiner including a transmission line having a first end coupled to the first output of the first amplifier and a second end coupled to the second output of the second amplifier. The method may also include performing simulations for a phase and group delay compensator based upon the center frequency, the frequency bandwidth, and a target group delay balance for the power amplifier system. The phase and group delay compensator is configured to reduce phase differences and group delay differences within the frequency bandwidth and to meet the target group delay balance. The method may also include selecting a first degree of coupling between the first pair of transmission lines and a second degree of coupling between the second pair of transmission lines based upon results from the simulations.

In a further aspect, a phase and group delay compensator may include a first input port, a second input port, a first output port, and a second output port. The phase and group delay compensator may also include a first pair of transmission lines having a first path input at the first input port and a first path output at the first output port and a second pair of transmission lines having a second path input at the second input port and a second path output at the second output port. At least one of the first pair or the second pair of transmission lines is coupled. The phase and group delay compensator is configured to reduce phase differences and group delay differences within a frequency band between the first path output and the second path output.

Additional embodiments and features are set forth in part in the description that follows and will become apparent to those skilled in the art upon examination of the specification or may be learned by the practice of the disclosed subject matter. A further understanding of the nature and advantages of the disclosure may be realized by reference to the remaining portions of the specification and the drawings, which form a part of this disclosure.

### BRIEF DESCRIPTION OF THE DRAWINGS

The description will be more fully understood with reference to the following figures and data graphs, which are presented as various embodiments of the disclosure and should not be construed as a complete recitation of the scope of the disclosure, wherein:
Figure 1 illustrates a conventional Doherty amplifier architecture in accordance with an embodiment of the disclosure;
Figure 2 illustrates phase differences and group delay differences between a first signal path including a main amplifier and a second signal path including a peaking amplifier of the conventional Doherty amplifier architecture of Figure 1 in accordance with an embodiment of the disclosure;
Figure 3 illustrates a schematic of a phase and group delay compensator in accordance with an embodiment of the disclosure;
Figure 4 illustrates a power amplifier system including the phase and group delay compensator of Figure 3 in accordance with an embodiment of the disclosure;
Figure 5A illustrates a modified Doherty power amplifier system including the phase and group delay compensator of Figure 3 in accordance with an embodiment of the disclosure;
Figure 5B illustrates an inverted modified Doherty power amplifier system including the phase and group delay compensator of Figure 3 in accordance with an embodiment of the disclosure;
FIG. 6 is a flow chart illustrating the steps of designing a phase and group delay compensator in a power amplifier system in accordance with an embodiment of the disclosure;
Figure 7A illustrates group delay differences for the phase and group delay compensator of Figure 3 at a center frequency of 2.3 GHz within a frequency bandwidth from 1.8 GHz to 2.8 GHz in accordance with an embodiment of the disclosure;
Figure 7B illustrates phase differences for the phase and group delay compensator of Figure 3 at the same center frequency and the same frequency bandwidth of Figure 7A in accordance with an embodiment of the disclosure;
Figure 8 illustrates phase differences and group delay between the first signal path including the main amplifier and the second signal path including the peaking amplifier of the modified Doherty power amplifier system of Figure 5A with compensation for phase differences at the same center frequency and the same frequency band of Figures 7A and 7B in accordance with an embodiment of the disclosure;
Figure 9A illustrates group delay balances for the phase and group delay compensator of Figure 3 at a center frequency of 2.0 GHz within a frequency bandwidth from 1.8 GHz to 2.2 GHz in accordance with an embodiment of the disclosure;
Figure 9B illustrates phase differences for the phase and group delay compensator of Figure 3 at the same center frequency and the same frequency bandwidth of Figure 9B in accordance with an embodiment of the disclosure; and
Figure 10A is a perspective view of a surface-mount phase and group delay compensator in accordance with an embodiment of the disclosure;
Figure 10B is a top view of the surface-mount phase and group delay compensator of Figure 10A in accordance with an embodiment of the disclosure; and
Figure 10C is a bottom view of the surface-mount phase and group delay compensator of Figure 10A in accordance with an embodiment of the disclosure.

### DETAILED DESCRIPTION

The disclosure may be understood by reference to the following detailed description, taken in conjunction with the drawings as described below. It is noted that, for purposes of illustrative clarity, certain elements in various drawings may not be drawn to scale.

There is a phase mismatch between a first signal path and a second signal path of a conventional Doherty amplifier architecture, which may cause inefficiency in re-combining power from the first signal path and the second signal path, and may reduce the output power from the conventional Doherty amplifier architecture. It is desirable to reduce the difference in group delay between the first and second signal paths and to increase the output power within the entire frequency bandwidth of the Doherty power amplifier.

A conventional approach for adding group delay introduces the phase delay at the center frequency. The conventional approach for adding group delay may include adding transmission lines in between. The phase mismatch between the signal path including the main amplifier and the signal path including the peaking amplifier still exists. Hence, the conventional approach cannot be directly used in the Doherty power amplifier application.

The disclosure addresses the issues of the conventional approach by offering a solution of adjusting group delay in a wide frequency range without causing the phase delay at the center frequency. The disclosure provides a phase and group delay compensator that is implemented into a power amplifier system.

The disclosed power amplifier system is modified from the Doherty amplifier architecture and may include the disclosed phase and group delay compensator after the splitter and prior to the Doherty power amplifier. Thus, the phase match and the group delay balance between the first signal path including the main amplifier and the second signal path including the peaking amplifier can be achieved in the frequency bandwidth.

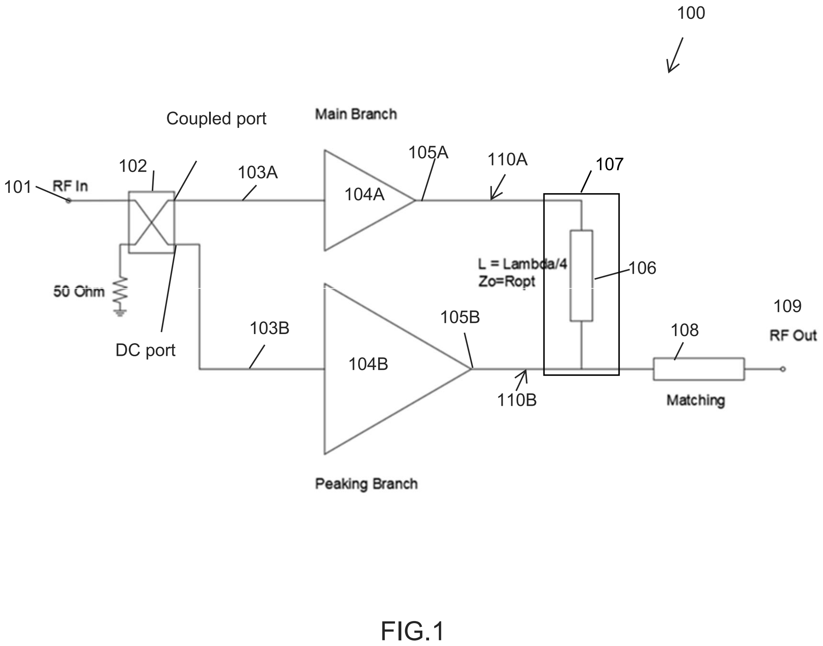

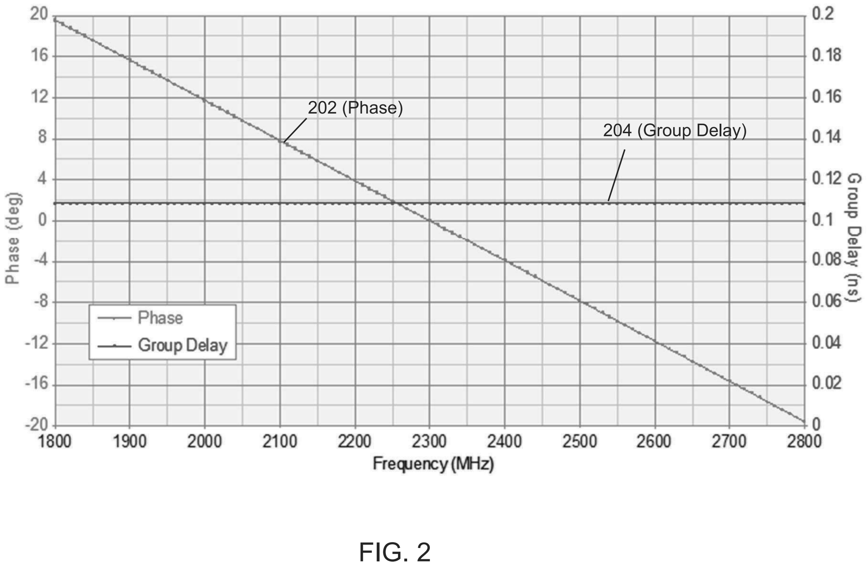

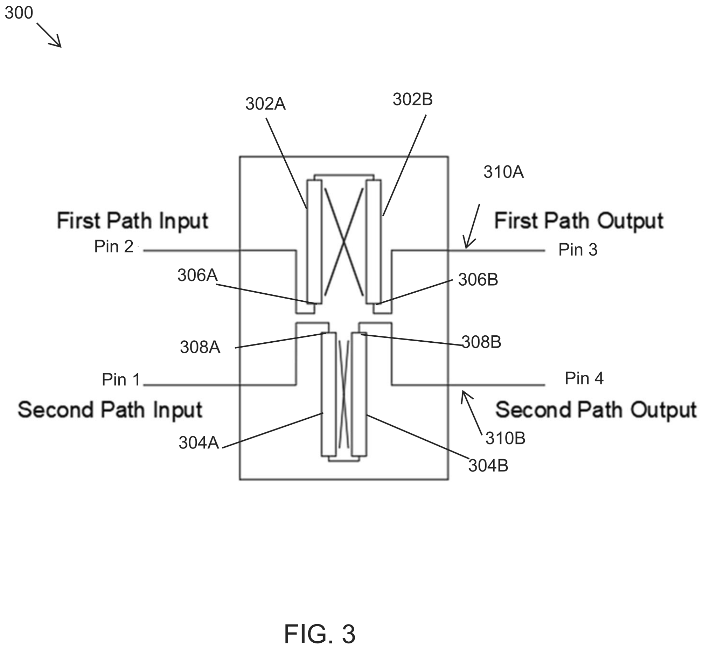

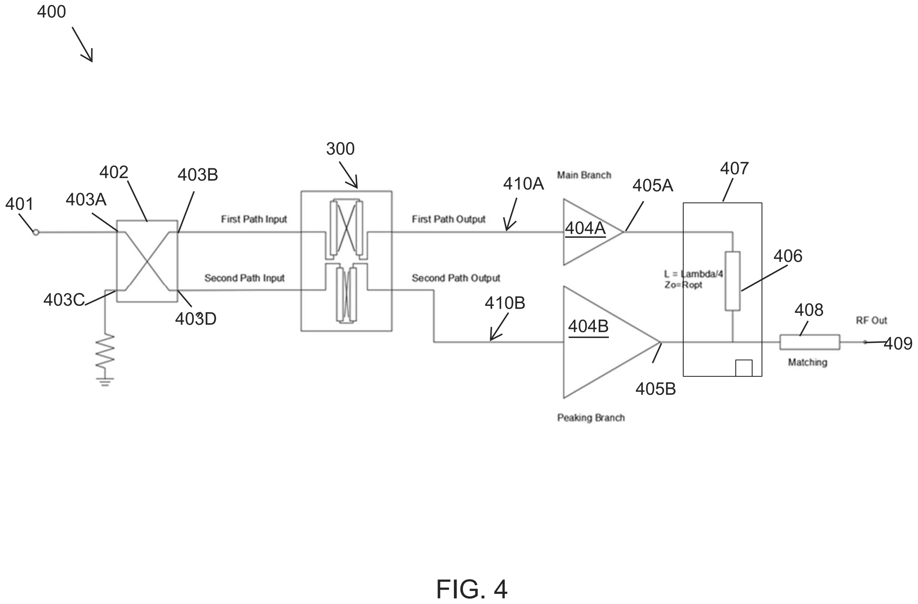

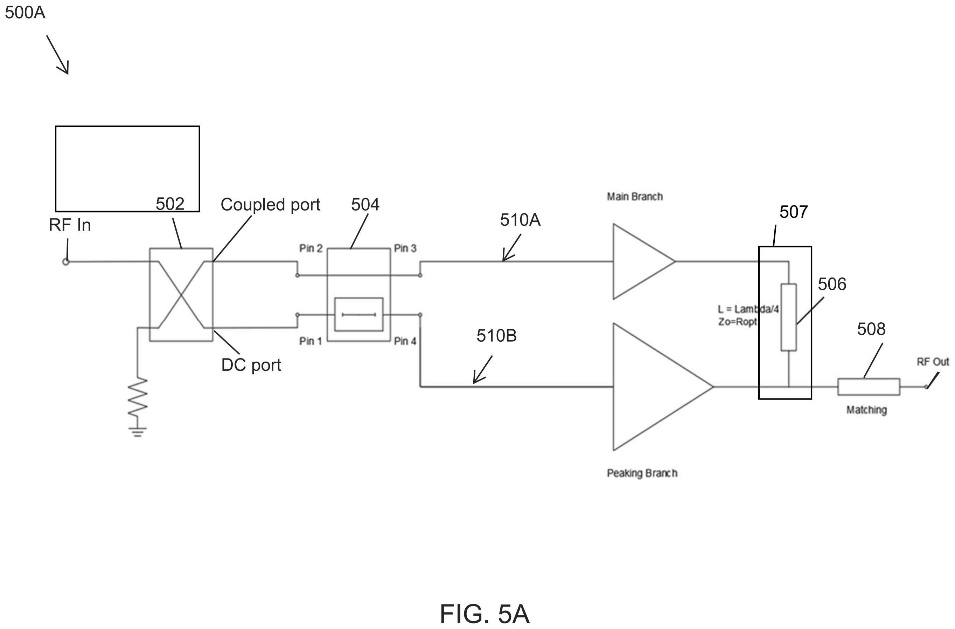

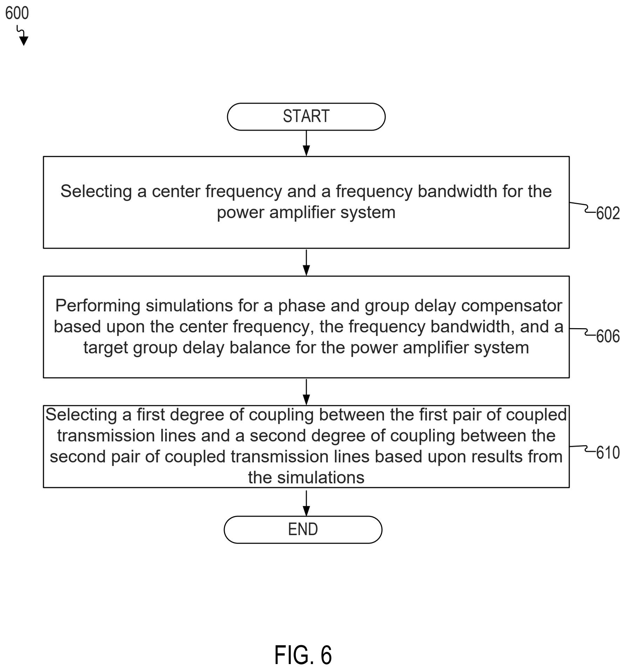

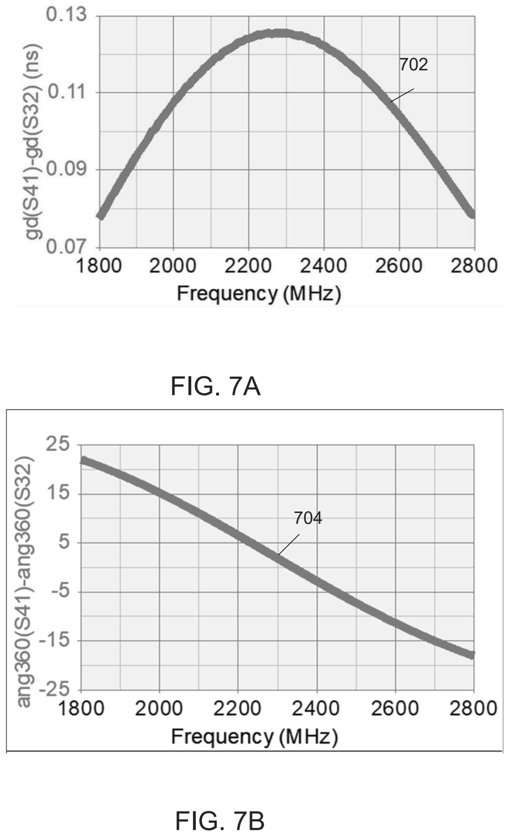

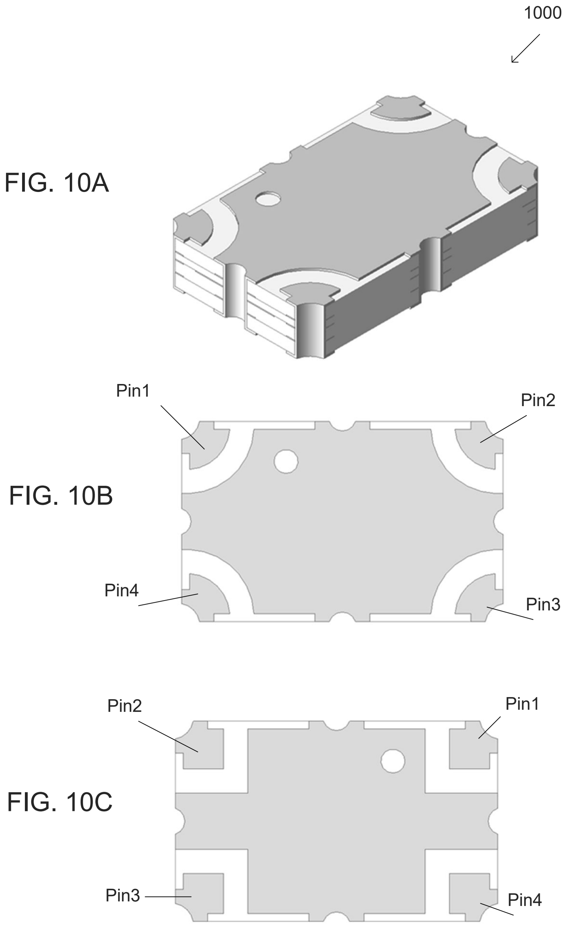

Descriptions of the conventional Doherty amplifier architecture are provided, as illustrated in Figure 1. The phase difference and group delay between the two signal paths for the conventional Doherty amplifier architecture are provided as illustrated in Figure 2. Descriptions of the disclosed phase and group delay compensator are provided, as illustrated in Figure 3. Descriptions of the disclosed power amplifier system including the phase and group delay compensator are also provided, as illustrated in Figure 4. Examples of the disclosed modified Doherty power amplifier system including the compensator are provided as illustrated in Figures 5A-5B. A flow chart for designing the phase and group delay compensator is provided in Figure 6. Examples of group delay balances and phase differences for different center frequencies and different frequency bands are illustrated in Figures 7A-7B, 8, 9A and 9B. An example surface mount phase and group delay compensator is provided as illustrated in Figures 10A-C.

Group delay refers to the time for a signal having a frequency band to pass through the power amplifier. Group delay balance refers to the consistency of time delay experienced by each subbranch of the power amplifier system. A power amplifier system with balanced group delay has equal time delay in each of its subbranches, thus minimizing distortion. In this disclosure, group delay balance is also referred to as group delay difference.

The group delay relates to the phase difference by Equation (1) as follows: $GD = d \left(phase\right) / d \left(2πF\right)$ Equation (1) where GD stands for group delay, F stands for frequency, d(phase) represents phase difference, and d(2πF) represents frequency bandwidth with conversion to degrees.

Phase balance is the deviation from an intended phase difference or a target phase difference. For example, an intended phase difference between two signal paths may be 90 degrees. In reality, the phase may be 90 +/- 5 degrees. In this case, the phase balance is 5 degrees. In this disclosure, the intended or target phase difference is zero. Thus, the phase balance and phase difference become the same. The term of "phase difference" is alternatively used with the term "phase balance."

Figure 1 illustrates a conventional Doherty amplifier architecture in accordance with an embodiment of the disclosure. As shown in Figure 1, a conventional Doherty amplifier architecture 100 includes an input splitter 102, a main branch or main amplifier 104A, a peaking branch or peaking amplifier 104B, and a Doherty combiner 107 including a transmission line 106. The main branch 104A is also referred to as a carrier amplifier. The peaking amplifier 104B is an auxiliary amplifier in parallel with the main amplifier 104A.

For designers, it is a challenge that when an amplifier is designed to operate efficiently at the peaks and with good linearity, the amplifier is much less efficient at average power levels. To address the challenge, the conventional Doherty amplifier architecture 100 uses two amplifiers to optimize the overall power amplification performance. The main amplifier 104A (or carrier amplifier) handles both a low-power region and a high-power region while the peaking amplifier 104B (or auxiliary amplifier) only handles a high-power region.

During operations, the main amplifier 104A remains in an "on" state while the peaking amplifier 104B remains in an "idle" state unless an input signal moves into the high-power region. In the high-power region, the peaking amplifier 104B turns on and provides additional amplification of the input signal to support high output power.

The splitter 102 divides an input signal 101 (e.g., RF input) into two input signals 103A and 103B for a first signal path or a first path 110A including the main branch 104A and a second signal path or second path 110B including the peaking branch or peaking amplifier 104B respectively, the two input signals 103A and 103B having a desired power ratio and a 90-degree phase difference, each of the two input signals 103A and 103B feeding the main branch 104A and the peaking branch 104B, respectively. The main branch 104A outputs an amplified signal 105A while the peaking branch 104B outputs an amplified signal 105B.

The Doherty combiner 107 combines the amplified signal 105A output from the first amplifier 104A via a quarter-wave (λ/4) transmission line 106 along the first path 110A and the amplified signal 105B output from the second amplifier 104B along the second path 410B. The conventional Doherty amplifier architecture 100 uses the quarter-wave (λ/4) transmission line 106 to provide an impedance inversion at the output of the main amplifier 104A. The quarter-wave transmission line 106 introduces a 90-degree phase shift.

The splitter or hybrid coupler 102 can maintain a 90-degree phase difference between a coupled port and a DC port in a wide bandwidth. Because the quarter-wave transmission line 106 introduces a 90-degree phase shift and the phase of the transmission line 106 varies proportionally with the frequency, the phase delays of the first signal path 110A including the main amplifier and the second signal path 100B including the peaking amplifier are equal at a center frequency, but are unequal across a frequency band around the center frequency.

The Doherty amplifier architecture 100 may also include a matching component 108 that provides an RF output 109. The matching component 108 is used to transform the output impedance of the Doherty amplifier architecture 100 to a desired impedance.

Figure 2 illustrates phase differences and group delay differences between a first signal path including a main amplifier and a second signal path including a peaking amplifier of the conventional Doherty amplifier architecture of Figure 1 for the frequency band of 1.8 GHz to 2.8 GHz in accordance with an embodiment of the disclosure. As shown in Figure 2, linear line 202 represents phase difference versus frequency, which has a negative slope, ranges from +20 degrees at 1.8 GHz to -20 degrees at 2.8 GHz, and zero degree near a center frequency 2.3 GHz. Also, linear line 204 represents group delay differences versus frequency, which is a horizontal line having a constant group delay difference of 0.11 ns within the frequency band from 1.8 GHz to 2.8 GHz.

As shown in Figure 2, the phase differences between the first signal path 110A including the main amplifier and the second signal path 110B including the peaking amplifier can deteriorate up to about +/- 20 degrees at both edges of the frequency band, as shown in Figure 2, while the phases are matched near the center frequency of about 2.3 GHz.

Figure 3 illustrates a schematic of a phase and group delay compensator in accordance with an embodiment of the disclosure. As shown in Figure 3, a phase and group delay compensator 300 includes a first path input, a first path output, a second path input, and a second path output.

In some variations, the first pair of coupled transmission lines 302A and 302B may be coupled, as illustrated in Figure 3. The first signal path 310A includes a first pair of coupled transmission lines 302A and 302B. At the first end 306A, one transmission line 302A is connected to the first path input along the first signal path 310A. At the second end 306B, the other one transmission line 302B is connected to the first path output along the first signal path.

In some variations, the first pair of coupled transmission lines 302A and 302B may be uncoupled, such as illustrated in Figure. 5A.

The phase and group delay compensator 300 also includes four ports 1, 2, 3, and 4, labeled as Pin 1, Pin 2, Pin 3, and Pin 4, respectively. Ports 1 and 2 are input ports while ports 3 and 4 are output ports.

In some embodiments, the first pair of transmission lines 302A and 302B may have a quarter wavelength, or other wavelength.

In some variations, the second pair of coupled transmission lines 304A and 304B may be coupled. A second signal path 310B includes a second pair of coupled transmission lines 304A and 304B. At a first end 308A, one transmission line 304A is connected to the second path input along the second signal path 310A. At the second end 308B, the other one transmission line 304B is connected to the second path output of the second signal path.

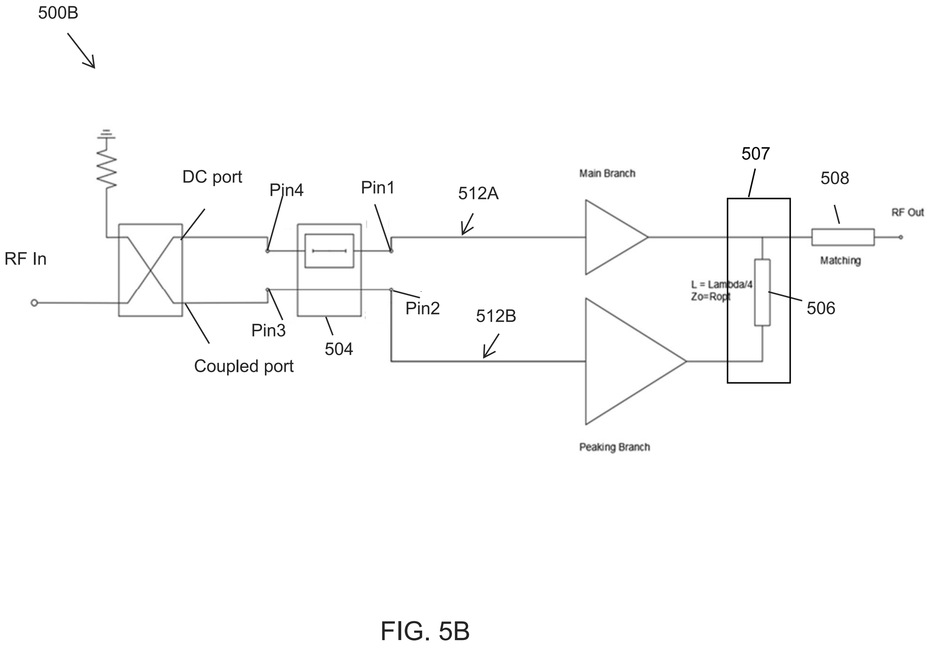

In some variations, the second pair of coupled transmission lines 304A and 304B may be uncoupled such as shown in Figure. 5B.

In some embodiments, the transmission lines 304A and 304B may have a quarter wavelength, or other wavelength.

While at the center frequency, both the first signal path 310A and the second signal path 310B have the same phase delay, e.g., 180 degrees in phase delay, from the first path input to the first path output or from the second path input to the second path output, assume that each of the first pair of coupled transmission lines and each of the second pair of coupled transmission lines having a quarter wavelength. A stronger coupling offers a steeper phase-frequency slope, or a longer group delay. The coupling difference between the two pairs of coupled transmission lines can be carefully chosen so that the group delay balance between the first signal path and the second signal path is within target values for the selected center frequency and frequency band.

In some embodiments, one of the couplings between the first pair of transmission lines or between the second pair of transmission lines may be looser or tighter than the other coupling.

In some embodiments, the first pair of coupled transmission lines 302A and 302B has a first distance between the first transmission line and the second transmission line that is large enough to uncouple the first transmission line and the second transmission line or small enough to loosely couple the first transmission line and the second transmission line.

In some embodiments, the second pair of coupled transmission lines 304A and 304B has a second distance between the third transmission line and the fourth transmission line that is small enough to tightly couple the third transmission line and the fourth transmission line.

Figure 4 illustrates a power amplifier system including the phase and group delay compensator of Figure 3 in accordance with an embodiment of the disclosure. As shown in Figure 4, a power amplifier system 400 includes the phase and group delay compensator 300 including a first path 410A and a second path 410B. The compensator 300 serves as a function block to adjust the group delay. The phase and group delay compensator 300 is inserted between a splitter 402 and a first power amplifier 404A and/or a second power amplifier 404B.

The splitter 402 may be a four-port device and may include an RF input port 403A, a coupled port 403B, a port 403C coupled to a resistor, and a DC port 403D. The splitter 402 receives an input signal 401 (e.g., RF input signal) and output divided signals via ports 403B and 403D, respectively to provide first path input signal and second path input signal to the compensator 300. Also, the input port 403A of the splitter 402 is configured to input an RF (radio frequency) power. The port 403C of the splitter 402 may be coupled to a resistor having a resistance of about 50 ohms and being grounded.

As shown in Figure 4, the first path input along the first path 410A is connected to the coupled port 403B of the splitter 402 or hybrid coupler, and the second path input along the second path 410B is connected to the DC port 403D of the splitter 402 or hybrid coupler.

In some embodiments, a 90-degree hybrid coupler is typically used as the splitter 402. The 90-degree hybrid coupler can conveniently achieve both the power dividing and the phase delay in a small package. The 90-degree hybrid coupler is a four-port device.

The coupling between the first pair of coupled transmission lines and the coupling between second pair of coupled transmission lines may be decided by a target group delay balance of the power amplifier system 400.

After the compensation of the group delay by the compensator 300, the first amplifier 404A (e.g., main branch or peaking amplifier) and the second amplifier 404B (e.g., peaking branch or peaking amplifier) in their respective first and second paths can be phase-matched not only around a center frequency but also within a frequency band. The first amplifier 404A outputs an amplified signal 405A while the second amplifier 404B outputs an amplified signal 405B.

The power amplifier system 400 may also include a power combiner 407 that combines the output signal 405A from the first amplifier 404A along the first path 410A and the output signal 405B from the second amplifier 404B along the second path 410B.

The power combiner 407 may include a transmission line 406 that has an input connected to the output of the first amplifier 404A. The transmission line 406 is configured to compensate for the phase difference of the power splitter 402 at the center frequency. The transmission line 406 is also an impedance transformer, for example, a quarter wavelength transformer, to change the load impedance for the first amplifier or main amplifier, which is called load modulating. In some embodiments, the transmission line 406 may be a quarter-wavelength transmission line between the main branch 404A and the peaking branch 404B, which is 90-degrees long, so that the divided input signals received from ports 403B and 403D respectively, amplified by the main branch 404A and the peaking branch 404B, can be re-combined with an equal phase in the power combiner 407 when a 90-degree hybrid coupler is used as the splitter 402.

In some embodiments, the transmission line 406 may be a quarter wavelength long.

The power amplifier system 400 may also include a matching component 408 that provides an RF output 409. The matching component 408 is used to transform the output impedance of the power amplifier system 400 to a desired impedance, typically 50 ohms, for efficient power transfer to the load at RF output 409. The matching component 408 may increase power transfer and reduce reflections at the RF output 409.

The matching component 408 is configured to match a resistance at the second end of the transmission line 406 of the system to a target resistance for RF output, such as a resistance of 50 ohms. The matching component 408 provides an RF output 409 and ensures that the load impedance seen by the main branch or main amplifier 404A and peaking branch or peaking amplifier 404B is optimized for efficient power transfer and high efficiency, especially at all power levels.

In some variations, the matching component 408 may include a quarter-wave transmission line to provide an impedance match to 50 Ω.

In some variations, the matching component may use lumped circuit elements rather than the transmission line.

In some embodiments, the matching component 408 may be a matching network.

Figure 5A illustrates a modified Doherty power amplifier system including the phase and group delay compensator of Figure 3 in accordance with an embodiment of the disclosure. As shown in Figure 5A, a modified Doherty power amplifier system 500A includes a phase and group delay compensator 504, which includes four ports 1, 2, 3, and 4, labeled as Pin 1, Pin 2, Pin 3, and Pin 4, respectively. Ports 1 and 2 are input ports while ports 3 and 4 are output ports. As illustrate, Pin 1 of the phase and group delay compensator 504 connects to a DC port of the splitter 502. Pin 2 of the phase and group delay compensator 504 connects to a coupled port of the splitter 502. Pin 3 connects to the main branch while pin 4 connects to the peaking branch.

As illustrated in Figure 5A, the first pair of transmission lines of the phase and group delay compensator 504 in a first path 510A is uncoupled. In this case, each of the first pair of transmission lines along the first path 510A is a quarter wavelength transmission line. The first pair of transmission lines degenerates to a one-half wavelength transmission line when they are uncoupled. As illustrated in Figure 5A, the second pair of transmission lines of the phase and group delay compensator 504 are coupled in a second path 510B. The modified Doherty power amplifier system 500A also includes a power combiner 507 including a transmission line 506 having similar function to the transmission line 406 as described above. The modified Doherty power amplifier system 500A also includes a matching component 508, having similar function to the matching component 408 as described above.

Figure 5B illustrates an inverted modified Doherty power amplifier system including the phase and group delay compensator of Figure 3 in accordance with an embodiment of the disclosure. As shown in Figure 5B, an inverted modified Doherty power amplifier system 500B includes phase and group delay compensator 504, which includes four ports 1, 2, 3, and 4, labeled as Pin 1, Pin 2, Pin 3, and Pin 4, respectively. Ports 1 and 2 are input ports while ports 3 and 4 are output ports. As illustrated, Pin 1 connects to the main branch while pin 2 connects to the peaking branch. Pin 3 of the phase and group delay compensator 504 connects to a coupled port of the splitter 502 while pin 4 of the phase and group delay compensator 504 connects to a DC port of the splitter 502.

As illustrated in Figure 5B, the first pair of transmission lines of the phase and group delay compensator 504 in the first path 512A is coupled. The second pair of transmission lines of the phase and group delay compensator 504 in a second path 512B is uncoupled. In this case, each of the second pair of transmission lines along the second path 512B is a quarter wavelength transmission line. Therefore, the second pair of transmission lines along the second path 512B degenerates to a one-half wavelength transmission line. The inverted modified Doherty power amplifier system 500B also includes a power combiner 507 including a transmission line 506 having similar function to the transmission line 406 as described above. The inverted modified Doherty power amplifier system 500B also includes a matching component 508, having similar function to the matching component 408 as described above.

### Simulations Performed to Determine Coupling Based Upon Target Group Delay Balance

FIG. 6 is a flow chart illustrating the steps of designing a phase and group delay compensator in a power amplifier system in accordance with an embodiment of the disclosure.

Method 600 is provided for designing a phase and group delay compensator in a power amplifier system. Method 600 may include selecting a center frequency and a frequency bandwidth for the power amplifier system at step 602.

The power amplifier system, such as those illustrated in Figures, 4, 5A, and 5B, may include a power splitter including a first output port and a second output port, where a first power output from the first output port has a phase difference from a second power output from the second output port, a phase and group delay compensator including a first pair of coupled transmission lines having a first path input and a first path output, and a second pair of coupled transmission lines having a second path input and a second path output. The power amplifier system may also include a first amplifier having a first input and a first output in a first path, and a second amplifier having a second input and a second output in a second path. The power amplifier system may also include a power combiner including a transmission line having a first end coupled to the first output of the first amplifier and a second end coupled to the second output of the second amplifier, where the first path output along the first path combines with the second path output along the second path at the second end of the transmission line.

Method 600 may also include performing simulations for a phase and group delay compensator based upon the center frequency, the frequency bandwidth, and a target group delay balance for the power amplifier system at step 606. The phase and group delay compensator is configured to reduce phase variations and group delay variations within the frequency bandwidth and to meet the target group delay balance.

Method 600 may also include selecting a first degree of coupling between the first pair of coupled transmission lines and a second degree of coupling between the second pair of coupled transmission lines based upon results from the simulations at step 610.

In some variations, the phase and group delay compensator may be a surface-mountable component.

In some variations, method 600 may also include determining a first distance between the first pair of coupled transmission lines based upon the second degree of coupling. Method 600 may also include determining a second distance between the second pair of coupled transmission lines based upon the second degree of coupling. Method 600 may also include implementing the first degree of coupling between the first pair of coupled transmission lines and the second degree of coupling between the second pair of coupled transmission lines in the surface-mountable component, which may further include determining dimensions of the surface-mountable component, and determining a layout for the surface-mountable component based upon simulations.

In some variations, the first degree of coupling or the second degree of coupling may increase reversely with the respective distance between the respective pair of coupled transmission lines such that the first degree of coupling or the second degree of coupling becomes stronger when the respective distance between the respective pair of coupled transmission lines becomes shorter.

In some variations, the power amplifier system may include a Doherty amplifier.

In some variations, method 600 may also include determining a group delay balance and a phase variation of the phase and group delay compensator within the frequency bandwidth.

In some variations, the transmission line of the power combiner may be configured to compensate for the phase difference of the power splitter at the center frequency.

In some variations, the coupling between the first pair of transmission lines of the compensator or between the second pair of transmission lines of the compensator may vary with a target group delay balance.

In some variations, the coupling between the first pair of transmission lines of the compensator or between the second pair of transmission lines of the compensator may vary with the center frequency and the frequency bandwidth.

As an example, to compensate for a target group delay of 0.11 ns for the frequency bandwidth ranging from 1.8 GHz to 2.8 GHz, as shown in Figure 2, the first pair of the transmission lines of the phase and group delay compensator 504 in the first path may be selected to be uncoupled transmission lines. The second pair of the transmission lines of the phase and group delay compensator 504 in the second path 510B may have a coupling of 8.9 dB.

The coupling (e.g., 8.9 dB) was estimated based upon simulations using RF circuit simulation tools, such as Cadence AWR Design Environment Platform, Advanced Design System (ADS) circuit design and simulation software, Genesys Electronic Design software, among others, which can be used for extracting the group delay of a pair of coupled transmission lines with the ends of the other pair of transmission lines to be tied together, which is also referred to as "uncoupled" pair of transmission lines.

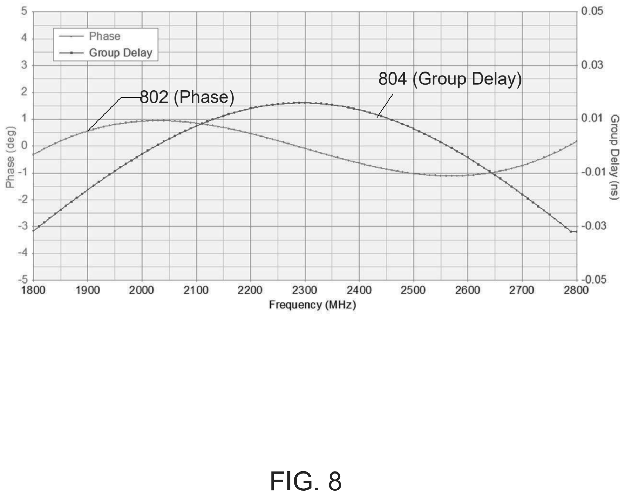

Various simulations were performed to demonstrate that the group delay and phase differences between a main signal path including a main amplifier and a peaking signal path including a peak amplifier can be reduced after compensation using the phase and group delay compensator 300. For example, Figures 7A-7B illustrate the group delay balances for the phase and group delay compensator, while Figure 8 illustrates the group delay balances for the power amplifier system 500A.

Figure 7A illustrates group delay balances for the phase and group delay compensator of Figure 3 at a center frequency of 2.3 GHz within a frequency bandwidth from 1.8 GHz to 2.8 GHz in accordance with an embodiment of the disclosure. As shown in Figure 7A, a horizontal axis represents frequency while a vertical axis represents group delay balance or difference, curve 702 represents group delay balance or difference versus frequency. In the vertical axis, gd(S41) means group delay from port 1 to port 4, while gd(S32) means group delay from port 2 to port 3, as illustrated in FIG. 3. The group delay balance or difference equals to gd(S41)- gd(S32), which varied with frequency in a bell curve. For example, the group delay difference had a peak value near the center frequency of 2.3 GHz and varied from about 0.07 ns to about 0.13 ns from 1.8 GHz to 2.8 GHz. The average group delay difference was about 0.10 ns.

Figure 7B illustrates phase balances for the phase and group delay compensator of Figure 3 at a center frequency of 2.3 GHz within a frequency bandwidth from 1.8 GHz to 2.8 GHz in accordance with an embodiment of the disclosure. As shown in Figure 7B, a horizontal axis represents frequency while a vertical axis represents phase difference, curve 704 represents phase difference versus frequency. Similarly, in the vertical axis, ang(S41) means phase from port 1 to port 4, while ang(S32) means phase from port 2 to port 3, as illustrated in FIG. 3. The phase difference equals to ang(S41)- ang(S32), which varied from about +20 degrees to about -20 degrees from 1.8 GHz to 2.8 GHz, which was created to counter the phase variations introduced by the transmission line 406 or 506 of the power combiner 407 or 507, such as shown in Figure 2.

Figure 8 illustrates phase differences and group delay between the first signal path including the main amplifier and the second signal path including the peaking amplifier of the modified Doherty power amplifier system of Figure 5A with compensation for phase differences at a center frequency of 2.3 GHz in accordance with an embodiment of the disclosure. As shown in Figure 8, a horizontal axis represents frequency, while a vertical axis on the right represents group delay and a vertical axis on the left represents phase difference. Curve 802 represents phase difference vs frequency, while curve 804 represents group delay balance vs frequency. As shown in Figure 8, phase differences varied +/- 1 degrees within the frequency band from 1.8 GHz to 2.8 GHz. For the same frequency range, group delay balances vary within -0.03 ns and +0.02 ns. The phase difference was reduced from +/- 20 degrees (without compensation) to +/- 1 degrees over the frequency bandwidth from 1.8 GHz to 2.8 GHz. Also, the group delay was reduced from 0.11 ns (without compensation) to about +/- 0.03 ns in the same frequency band.

For the power amplifier system 400 (e.g., modified Doherty power amplifier system 500A or 500B) that work at different center frequencies and bandwidths, for a target group delay, the coupling of each of the first and second pairs of coupled transmission lines may be adjusted accordingly by performing simulations using the simulation tools to obtain a better performance in compensation for phase and group delay. The physical lengths of the first and second pairs of transmission lines of the phase and group delay compensator may also be adjusted with center frequency. However, the electrical lengths of the first pair or the second pair of the coupled transmission lines of the phase and group delay compensator remain to be a fixed value (e.g., 90 degrees) at their center frequencies for the power amplifier system 400 (e.g., Doherty power amplifiers).

### Surface-Mountable Phase and Group Delay Compensator

The phase and group delay compensator 300 can be easily realized into a surface mountable component, using Low Temperature Co-fired Ceramic (LTCC) process, which is a multilayered ceramic substrate technology for creating miniaturized electronic devices and substrates. The phase and group delay compensator can also be realized in multilayer printed circuit board (PCB) process technology. The surface mount phase and group delay compensator offers a convenient and easy layout for power amplifier designs. The phase and group delay compensator can also use a semiconductor manufacturing process,

In one embodiment, the disclosed phase and group delay compensator may be a standalone surface mountable component or device. The implementation of the disclosed phase and group delay compensator may use a LTCC process.

In another embodiment, the disclosed phase and group delay compensator may be a standalone surface mountable component. The implementation of the disclosed phase and group delay compensator may use a multi-layer PCB process.

In a further embodiment, the disclosed phase and group delay compensator may be a part of an integrated circuit (IC). The implementation of the disclosed phase and group delay compensator may use a semiconductor manufacturing process, which includes wafer fabrication, such as silicon or other semiconductor materials, deposition of various materials (conductors, insulators, etc.) onto the wafer, lithography that forms photomasks with circuit designs by using light, creating the desired circuit features, etching and doping to build up the complex layers of a chip.

In some embodiments, the phase and group delay compensator can be used in other applications where the group delay may be adjusted within a frequency band while maintaining the center frequency phase delay.

### EXAMPLES

The following examples are for illustration purposes only. It will be apparent to those skilled in the art that many modifications, both to materials and methods, may be practiced without departing from the scope of the disclosure.

### Variations in Center Frequency and Frequency Bandwidth

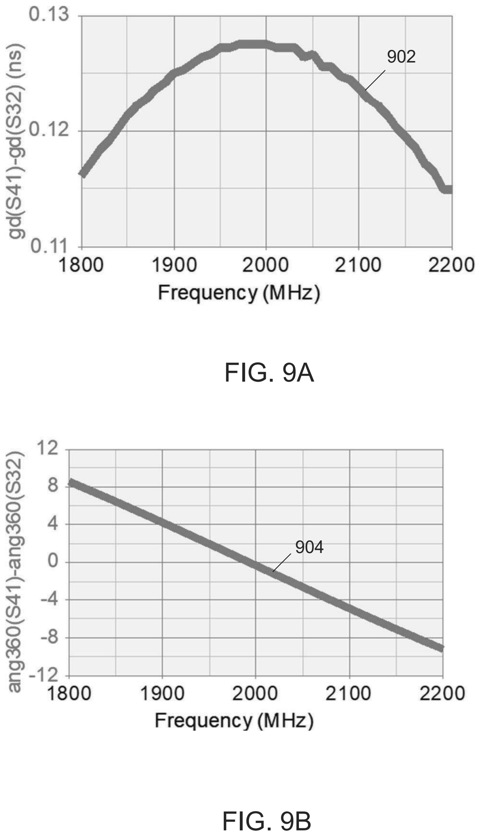

Figure 9A illustrates delay balances for the phase and group delay compensator of Figure 3 at a lower center frequency of 2.0 GHz within a smaller frequency bandwidth from 1.8 GHz to 2.2 GHz in accordance with an embodiment of the disclosure. As shown in Figure 9A, a horizontal axis represents frequency while a vertical axis represents group delay balance or difference, curve 902 represents group delay balance versus frequency. In the vertical axis, gd(S41) means group delay from port 1 to port 4, while gd(S32) means group delay from port 2 to port 3, as illustrated in FIG. 3. The group delay balance or difference equals to gd(S41)- gd(S32), which varied with frequency in a bell curve. For example, the group delay had a peak value near the center frequency of 2.0 GHz and varied from about 0.115 ns to about 0.128 ns within the frequency band from 1.8 GHz to 2.2 GHz. The average group delay was about 0.12 ns. Compared to curve 702 as shown in Figure 7A, the curve 902 shows different group delay variations versus frequency when the frequency band was changed to 1.8 GHz to 2.2 GHz.

Figure 9B illustrates phase differences for the phase and group delay compensator of Figure 3 at a lower center frequency of 2.0 GHz within a smaller frequency bandwidth from 1.8 GHz to 2.2 GHz in accordance with an embodiment of the disclosure. As shown in Figure 9B, a horizontal axis represents frequency while a vertical axis represents phase difference, curve 904 represents the phase difference versus frequency. Similarly, in the vertical axis, ang(S41) means phase from port 1 to port 4, while ang(S32) means phase from port 2 to port 3, as illustrated in FIG. 3. The phase difference equals to ang(S41)- ang(S32), which varied from about +8 degrees to about -10 degrees from 1.8 GHz to 2.2 GHz, which was created to counter the phase variations introduced by the transmission line 406 or 506 of the power combiner 407 or 507. Compared to curve 704 as shown in Figure 7B, the curve 904 shows different phase variations versus frequency when the frequency band was changed to 1.8 GHz to 2.2 GHz.

### Surface-Mountable Component

Figures 10A-10C illustrate a perspective view of a surface-mount phase and group delay compensator 1000, a top view of the surface-mount phase and group delay compensator 1000, and a bottom view of the surface-mount phase and group delay compensator 1000 in accordance with an embodiment of the disclosure. As illustrated, a surface-mount phase and group delay compensator 1000 includes four ports, i.e., labeled as pin 1, pin 2, pin 3, and pin 4. For example, the surface-mount phase and group delay compensator 1000 may have dimensions of about 0.125 inches by about 0.2 inches.

When the dimensions of the surface-mount phase and group delay compensator 1000 were about 0.125 inches by about 0.2 inches, when the surface-mount phase and group delay compensator 1000 had a center frequency of 2.3 GHz and a bandwidth ranging from 1.8 GHz to 2.8 GHz, the group delay balance was 0.10 +/- 0.03 ns and phase difference was within 0+/- 3 degrees at 2.3 GHz. The coupling for the second pair of transmission lines having quarter wavelengths in Figure 5A was 8.9 dB while the first pair of transmission lines having quarter wavelengths was uncoupled.

When the dimensions of the surface-mount phase and group delay compensator 1000 were about 0.125 inches by about 0.2 inches, when the surface-mount phase and group delay compensator 1000 had a lower center frequency of 2.0 GHz and a smaller bandwidth ranging from 1.8 GHz to 2.2 GHz, the respective group delay balance was 0.12 +/- 0.015 ns, which is slightly different from the values of 0.10 +/- 0.03 ns at the center frequency of 2.3 GHz. The respective phase difference was within 0+/- 2 degrees at 2.0 GHz, which is slightly different from the values within 0+/- 3 degrees at the center frequency of 2.3 GHz. The coupling for the second pair of transmission lines having quarter wavelengths in Figure 5A was 8.3 dB while the first pair of transmission lines having quarter wavelengths was uncoupled, which is slightly different from the coupling of 8.9 dB for the center frequency of 2.3 GHz and the frequency bandwidth from 1.8 GHz to 2.8 GHz.

Clause 1. A phase and group delay compensator comprises: a first input port; a second input port; a first output port; a second output port; a first pair of transmission lines having a first path input at the first input port and a first path output at the first output port; and a second pair of transmission lines having a second path input at the second input port and a second path output at the second output port, wherein at least one of the first pair or the second pair of transmission lines is coupled, wherein the phase and group delay compensator is configured to reduce phase differences and group delay differences within a frequency band between the first path output and the second path output.

Clause 2. The phase and group delay compensator of clause 1, wherein the phase and group delay compensator is a standalone surface-mountable device.

Clause 3. The phase and group delay compensator of clause 1, wherein the phase and group delay compensator is part of an integrated circuit (IC).

Clause 4. A power amplifier system comprising the phase and group delay compensator of any one of clauses 1-3, the power amplifier system further comprising: a power splitter comprising a first port and a second port, wherein a first power output from the first port has a phase difference from a second power output from the second port; a first amplifier having a first input and a first output in the first path; a second amplifier having a second input and a second output in the second path; a power combiner having a transmission line having a first end coupled to the first output of the first amplifier and a second end coupled to the second output of the second amplifier, wherein the transmission line of the power combiner is configured to compensate for the phase difference of the power splitter at a center frequency.

Clause 5. The power amplifier system of clause 4, wherein the at least one of the first pair or the second pair of transmission lines has a distance between the first pair or the second pair of transmission lines that is small enough to couple the first pair or the second pair of transmission lines.

Clause 6. The power amplifier system of any one of clauses 4-5, wherein the at least one of the first pair or second pair of transmission lines has a distance between the first pair of transmission lines or the second pair of transmission lines that is large enough to uncouple the first pair of transmission lines or the second pair of transmission lines.

Clause 7. The power amplifier system of any one of clauses 4-6, wherein the first path output along the first path combines with the second path output along the second path at the second end of the transmission line of the power combiner.

Clause 8. The power amplifier system of any one of clauses 4-7, wherein the power amplifier system further comprises a matching component configured to match a resistance at the second end of the transmission line of the power combiner to a target resistance for RF output.

Clause 9. The power amplifier system of any one of clauses 4-8, wherein the first amplifier comprises a main branch of a Doherty amplifier, wherein the second amplifier comprises a peaking branch of the Doherty amplifier.

Clause 10. The power amplifier system of any one of clauses 4-9, wherein the power splitter is a hybrid coupler.

Clause 11. The power amplifier system of clause 10, wherein the second port of the power splitter is a DC port and has a phase delay of 90° from the first output through the first port of the power splitter, wherein the transmission line of the power combiner is configured to shift phase by 90°.

Clause 12. The power amplifier system of clause 10, wherein the power splitter comprises a first input port configured to input an RF (radio frequency) power and a second input port coupled to a resistor having a resistance of 50 ohms and being grounded.

Clause 13. A method for providing the phase and group delay compensator of a power amplifier system of any one of clauses 4-12, the method comprising: selecting a center frequency and a frequency bandwidth for the power amplifier system; performing simulations for the phase and group delay compensator based upon the center frequency, the frequency bandwidth, and a target group delay balance for the power amplifier system, wherein the phase and group delay compensator is configured to reduce phase differences and group delay differences within the frequency bandwidth and to meet the target group delay balance; and selecting a first degree of coupling between the first pair of transmission lines and a second degree of coupling between the second pair of transmission lines based upon results from the simulations.

Clause 14. The method of clause 13, wherein a first distance between the first pair of transmission lines is selected to be small enough to couple the first pair or the second pair of transmission lines, wherein a second distance between the first pair of transmission lines or the second pair of transmission lines is selected to be large enough to uncouple the second pair of transmission lines.

Clause 15. The method of any one of clauses 13-14, further comprising: determining the first distance between the first pair of transmission lines based upon the first degree of coupling; determining the second distance between the second pair of transmission lines based upon the second degree of coupling; determining dimensions of the standalone surface-mountable device of claim 2; and determining a layout for the surface-mountable device based upon simulations, wherein the first degree of coupling or the second degree of coupling increases reversely with a respective distance between a respective pair of transmission lines such that the first degree of coupling or the second degree of coupling becomes stronger when the respective distance between the respective pair of transmission lines becomes shorter; and determining a group delay balance and a phase difference of the phase and group delay compensator between the first path and the second path within the frequency bandwidth.

Any ranges cited herein are inclusive. The terms "substantially" and "about" used throughout this Specification are used to describe and account for small fluctuations. For example, they can refer to less than or equal to ± 5%, such as less than or equal to ± 2%, such as less than or equal to ± 1%, such as less than or equal to ± 0.5%, such as less than or equal to ± 0.2%, such as less than or equal to ± 0.1%, such as less than or equal to ± 0.05%.

Having described several embodiments, it will be recognized by those skilled in the art that various modifications, alternative constructions, and equivalents may be used without departing from the spirit of the invention. Additionally, a number of well-known processes and elements have not been described in order to avoid unnecessarily obscuring the invention. Accordingly, the above description should not be taken as limiting the scope of the invention.

Those skilled in the art will appreciate that the presently disclosed embodiments teach by way of example and not by limitation. Therefore, the matter contained in the above description or shown in the accompanying drawings should be interpreted as illustrative and not in a limiting sense. The following claims are intended to cover all generic and specific features described herein, as well as all statements of the scope of the method and system, which, as a matter of language, might be said to fall therebetween.

## Claims

1. A phase and group delay compensator comprises:
a first input port;
a second input port;
a first output port;
a second output port;
a first pair of transmission lines having a first path input at the first input port and a first path output at the first output port; and
a second pair of transmission lines having a second path input at the second input port and a second path output at the second output port,
wherein at least one of the first pair or the second pair of transmission lines is coupled,
wherein the phase and group delay compensator is configured to reduce phase differences and group delay differences within a frequency band between the first path output and the second path output.

2. The phase and group delay compensator of claim 1, wherein the phase and group delay compensator is a standalone surface-mountable device.

3. The phase and group delay compensator of claim 1, wherein the phase and group delay compensator is part of an integrated circuit (IC).

4. A power amplifier system comprising the phase and group delay compensator of any one of claims 1-3, the power amplifier system further comprising:
a power splitter comprising a first port and a second port, wherein a first power output from the first port has a phase difference from a second power output from the second port;
a first amplifier having a first input and a first output in the first path;
a second amplifier having a second input and a second output in the second path;
a power combiner having a transmission line having a first end coupled to the first output of the first amplifier and a second end coupled to the second output of the second amplifier, wherein the transmission line of the power combiner is configured to compensate for the phase difference of the power splitter at a center frequency.

5. The power amplifier system of claim 4, wherein the at least one of the first pair or the second pair of transmission lines has a distance between the first pair or the second pair of transmission lines that is small enough to couple the first pair or the second pair of transmission lines.

6. The power amplifier system of any one of claims 4-5, wherein the at least one of the first pair or second pair of transmission lines has a distance between the first pair of transmission lines or the second pair of transmission lines that is large enough to uncouple the first pair of transmission lines or the second pair of transmission lines.

7. The power amplifier system of any one of claims 4-6, wherein the first path output along the first path combines with the second path output along the second path at the second end of the transmission line of the power combiner.

8. The power amplifier system of any one of claims 4-7, wherein the power amplifier system further comprises a matching component configured to match a resistance at the second end of the transmission line of the power combiner to a target resistance for RF output.

9. The power amplifier system of any one of claims 4-8, wherein the first amplifier comprises a main branch of a Doherty amplifier, wherein the second amplifier comprises a peaking branch of the Doherty amplifier.

10. The power amplifier system of any one of claims 4-9, wherein the power splitter is a hybrid coupler.

11. The power amplifier system of claim 10, wherein the second port of the power splitter is a DC port and has a phase delay of 90° from the first output through the first port of the power splitter, wherein the transmission line of the power combiner is configured to shift phase by 90°.

12. The power amplifier system of claim 10, wherein the power splitter comprises a first input port configured to input an RF (radio frequency) power and a second input port coupled to a resistor having a resistance of 50 ohms and being grounded.

13. A method for providing the phase and group delay compensator of a power amplifier system any one of claims 4-12, the method comprising:
selecting a center frequency and a frequency bandwidth for the power amplifier system;
performing simulations for the phase and group delay compensator based upon the center frequency, the frequency bandwidth, and a target group delay balance for the power amplifier system, wherein the phase and group delay compensator is configured to reduce phase differences and group delay differences within the frequency bandwidth and to meet the target group delay balance; and
selecting a first degree of coupling between the first pair of transmission lines and a second degree of coupling between the second pair of transmission lines based upon results from the simulations.

14. The method of claim 13, wherein a first distance between the first pair of transmission lines is selected to be small enough to couple the first pair or the second pair of transmission lines, wherein a second distance between the first pair of transmission lines or the second pair of transmission lines is selected to be large enough to uncouple the second pair of transmission lines.

15. The method of any one of claims 13-14, further comprising:
determining the first distance between the first pair of transmission lines based upon the first degree of coupling;
determining the second distance between the second pair of transmission lines based upon the second degree of coupling;
determining dimensions of the standalone surface-mountable device of claim 2; and
determining a layout for the surface-mountable device based upon simulations, wherein the first degree of coupling or the second degree of coupling increases reversely with a respective distance between a respective pair of transmission lines such that the first degree of coupling or the second degree of coupling becomes stronger when the respective distance between the respective pair of transmission lines becomes shorter; and
determining a group delay balance and a phase difference of the phase and group delay compensator between the first path and the second path within the frequency bandwidth.
